# EUROPÄISCHE PATENTANMELDUNG

(11) **EP 2 048 060 A2**
(43) Veröffentlichungstag der Anmeldung: **15.04.2009**
(21) Anmeldenummer: 08165456.8
(22) Anmeldetag: 30.09.2008
(51) Int. Cl.: B62D 5/00, H05K 5/00

(54) **Steuergerät**

(30) Priorität: 08.10.2007 DE 102007000960
(71) Anmelder: ZF-Lenksysteme GmbH, 73527 Schwäbisch Gmünd (DE)
(72) Erfinder: Heger, Markus, 73565 Spraitbach (DE); Karch, Gerald, 73527, Schwäbisch Gmünd (DE); Walz, Stefan, 73529, Schwäbisch Gmünd (DE)

(57) **Zusammenfassung**

Die Erfindung betrifft ein Steuergerät (30) insbesondere für eine Lenkung mit elektrischer Hilfskraftunterstützung, mit einer Grundplatte (31), einer elektronische Bauelemente zur Signalverarbeitung aufweisenden Signalelektronik (33), einer elektronische Bauelemente zur Leistungsübertragung aufweisenden Leistungselektronik (32) und einem Halter (34) zum Halten der Signalelektronik (33). Nach dem Stand der Technik wird die Leistungselektronik bisher durch Verschrauben oder Verkleben mit der Grundplatte verbunden. Dies ist jedoch ziemlich zeit- und materialaufwändig. Deshalb schlägt die vorliegende Erfindung vor, die Leistungseiektronik (32) mit Hilfe des Halters (34) gegen die Grundplatte (31) zu pressen.

## Beschreibung

Die Erfindung betrifft ein Steuergerät, insbesondere für eine Lenkung mit elektrischer Hilfskraftunterstützung, mit einer Grundplatte, eine elektronische Bauelemente zur Signalverarbeitung aufweisenden Signalelektronik, einer elektronische Bauelemente zur Leistungsübertragung aufweisenden Leistungselektronik und einem Halter zum Halten der Signalelektronik.

Die Leistungselektronik erzeugt große Wärmemengen, die zuverlässig abgeführt werden müssen, um die elektronischen Bauelemente vor ihrer Zerstörung zu schützen. Deshalb ist es wichtig, dass die Leistungselektronik mit der Grundplatte thermisch verbunden ist, da sich die Grundplatte seht gut zur Aufnahme der von der Leistungselektronik erzeugten Wärme eignet. Gemäß dem Stand der Technik wird die Leistungselektronik bisher durch Verschrauben oder Verkleben mit der Grundplatte verbunden. Diese Verbindungsmöglichkeiten sind jedoch ziemlich zeit- und materialaufwändig und erhöhen üblicherweise den thermischen Widerstand.

Die Erfindung hat die Aufgabe, ein Steuergerät der eingangs genannten Art dahingehend zu verbessern, dass der Aufwand zum Verbinden der Leistungselektronik mit der Grundplatte reduziert wird.

Die Erfindung löst die gestellte Aufgabe mit einem Steuergerät der eingangs genannten Art, bei dem erfindungsgemäß die Leistungselektronik mit Hilfe des Halters gegen die Grundplatte pressbar ist. Der Halter übernimmt also zukünftig zusätzlich die Aufgabe die Leistungselektronik mit der Grundplatte zu verbinden, so dass durch Wärmeleitung die von der Leistungselektronik erzeugte Wärme zuverlässig an die Grundplatte abgegeben werden kann. Verschraubungen, Verklebungen und dergleichen können also zukünftig entfallen. Folglich wird durch das erfindungsgemäße Steuergerät Montagezeit eingespart und der Materialaufwand reduziert.

Die beiden folgenden Montageabläufe bieten sich für das erfindungsgemäße Steuergerät besonders an. Bei der ersten Montagevariante können die Bauelemente der Leistungselektronik auf der Grundplatte platziert werden. Im nächsten Montageschritt kann der Halter zusammen mit den Bauelementen der Signalelektronik auf die Grundplatte montiert werden. Der Halter presst dann die Leistungselektronik gegen die Grundplatte, so dass ein zuverlässiger Wärmeübergang sichergestellt ist.

Bei der zweiten Montagevariante können die Bauelemente der Leistungselektronik auf dem Halter befestigt und dann mit der Grundplatte verbunden werden. Bei dieser Alternative kann die Signalelektronik bereits vor der Vebindung des Halters mit der Grundplatte oder danach an dem Halter montiert sein.

Der Halter kann als ein Rahmen ausgeführt sein. Die Signalelektronik kann dann einfach und zuverlässig auf dem Rahmen befestigt werden.

Der Halter lässt sich schnell und zuverlässig an der Grundplatte und/oder an der Signalelektronik befestigen, wenn der Halter an der Grundplatte und/oder an der Signalelektronik mittels Rasthaken und/oder Schrauben und/oder Sprengringen und/oder Nieten befestigbar ist.

Die Positionierung der Leistungselektronik erfolgt vorteilhafterweise über die Formgebung der Grundplatte. Hierzu kann die Grundplatte mit Darchbrüctien und/oder Vertiefungen zur Aufnahme der Leistungselektronik versehen sein. Hierbei ist es möglich, die Leistungselektronik entlang der Kanten der Durchbrüche und/oder der Vertiefungen auszurichten.

Aus Gründen einer schnellen und zuverlässigen Montage ist es sinnvoll die Leistungselektronik ebenfalls mit Rasthaken an dem Halter zu fixieren.

Zum Ausgleich von Toleranzen und zur Verbesserung der Wärmeleitung kann zwischen der Leistungselektronik und der Grundplatte ein Wärme leitendes Medium vorgesehen werden.

Gute Ergebnisse erreicht man, wenn das Wärme leitende Medium eine Wärmeleitpaste, eine Wärmeleitfolie oder dergleichen ist.

Zur Verbesserung des thermischen Überganges zwischen der Leistungselektronik und der Grundplatte kann die Leistungselektronik mit Federelementen an die Grundplatte gepresst werden.

Elektrische Verbindungen zwischen der Leistungselektronik und der Signalelektronik können durch Bond- und/oder Lötverbindungen und/oder Federelementen sicher hergestellt werden.

Die Erfindung betrifft ferner eine Lenkung, insbesondere für ein Kraftfahrzeug, die erfindungsgemäß mit einem Steuergerät nach einem der Ansprüche 1 bis 9 ausgerüstet ist.

Nachfolgend werden verschiedene Ausführungsbeispiele eines erfindungsgemäßen Steuergerätes anhand der beiliegenden Zeichnungen näher erläutert.

Im Einzelnen zeigen:
- Fig. 1: eine Schnittansicht durch eine erste Ausführungsform des Steuergerätes;
- Fig. 2: eine perspektivische Ansicht auf eine zweite Ausführungsform des Steuergerätes;
- Fig. 3: eine perspektivische Detailansicht einer dritten Ausführungsform des Steuergerätes.

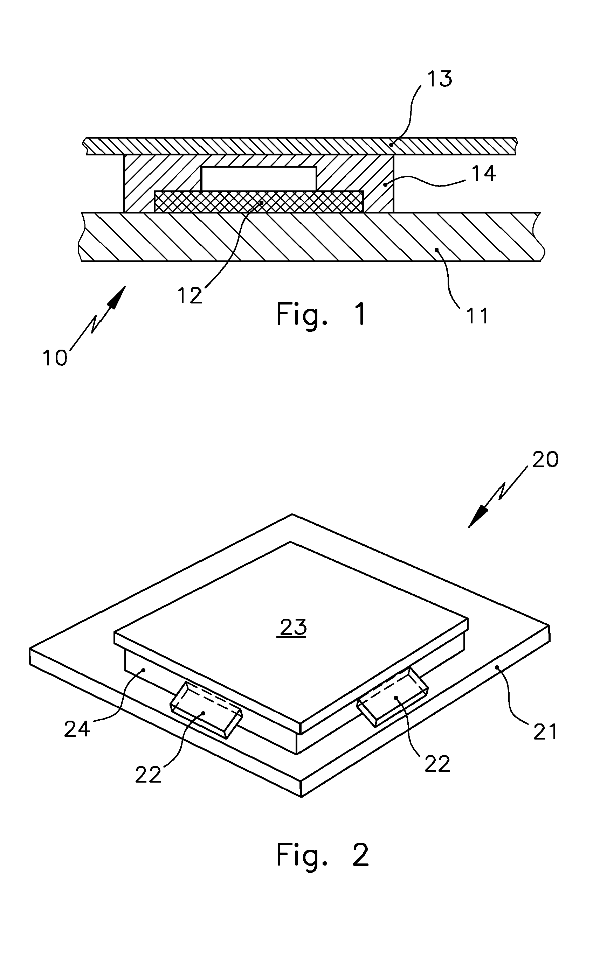

Fig. 1 zeigt ein Steuergerät 10 mit einer Grundplatte 11, einer Leistungselektronik 12 und einer Signalelektronik 13. Auf der Grundplatte 1.1 ist ein Halter 1.4 angeordnet. Der Halter 1.4 drückt die Leistungselektronik 12 gegen die Grundplatte 11 und gewährleistet dadurch einen sicheren Wärmeübergang von der durch die Leistungselektronik 12 erzeugten Wärme auf die Grundplatte 11.

Fig. 2 zeigt ein Steuergerät 20, mit einer Grundplatte 21, einer Leistungselektronik 22 und einer Signalelektronik 23. Ein Halter 24 presst die Leistungselektronik 22 gegen die Grundplatte 21 und trägt gleichzeitig die Signalelektronik 23. Der Halter 24 ist als ein Rahmen ausgeführt. Somit ist die Signalelektronik einfach und zuverlässig auf dem Halter 24 befestigbar.

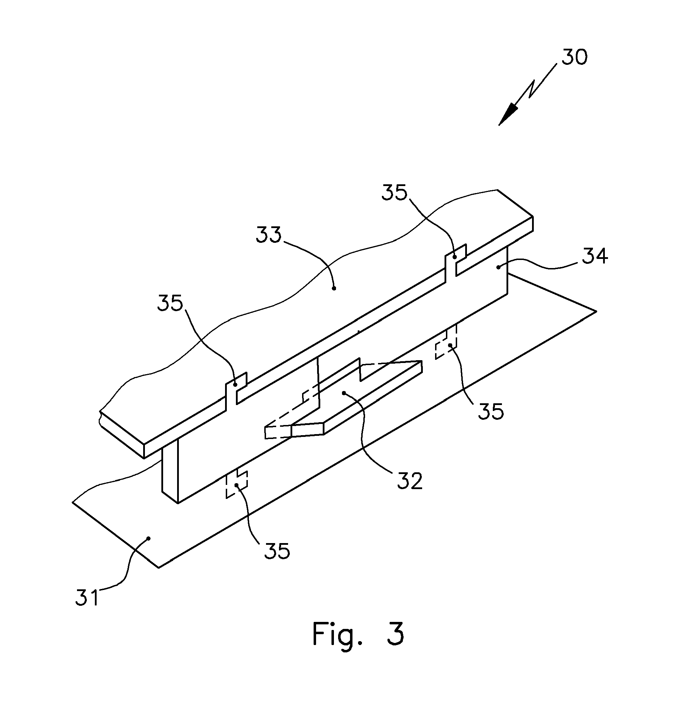

Ein Steuergerät 30 weist eine Grundplatte 31, eine Leistungselektronik 32, eine Signalelektronik 33 und einen Halter 34 auf. Der Halter und 34 ist mit Rasthaken 35 ausgerüstet (siehe Fig. 3) . Durch die Rasthaken 35 kann der Halter 34 an der Grundplatte 31 und an der Signalelektronik 33 fixiert werden, bevor die endgültige Montage von Signalelektronik, Leistungselektronik und Halter auf der Grundplatte erfolgt.

Grundsätzlich ist es jedoch auch möglich den Halter 34 alternativ oder zusätzlich durch Schrauben und/oder Sprengringe und/oder Nieten mit der Grundplatte 31 und der Signalelektronik 33 zu verbunden.

Die Leistungselektronik 32 kann ebenfalls mittels hier nacht näher dargestellter Rasthaken an dem Halter 34 befestigt werden, wodurch ein optimaler Wärmeübergang von der Leistungselektronik 32 auf die Grundplatte 31 unterstützt und ein einfacher Montageprozess erreicht wird.

Zwischen der Grundplatte 31 und der Leistungselektronik 32 kann eine hier ebenfalls nicht gezeigte Wärmeleitpaste oder Wärmeleitfolie vorgesehen werden, um Toleranzen auszugleichen und die Wärmeleitung zwischen der Leistungselektronik 32 und der Grundplatte 31 zu verbessern.

Aus demselben Grund können nicht dargestellte Federelemente die Leistungselektronik 32 gegen die Grundplatte 31 pressen.

### BEZUGSZEICBENLISTE

- 10: Steuergerät
- 11: Grundplatte
- 12: Leistungselektronik
- 13: Signalelektronik
- 14: Halter

- 20: Steuergerät
- 21: Grundplatte
- 22: Leistungselektronik
- 23: Signalelektronik
- 24: Halter

- 30: Steuergerät
- 31: Grundplatte
- 32: Leistungselektronik
- 33: Signalelektronik
- 34: Halter
- 35: Rasthaken

## Patentansprüche

1. Steuergerät (10, 20, 30) insbesondere für eine Lenkung mit elektrischer Hilfskraftunterstütsung, mit einer Grundplatte (11, 21, 31), einer elektronische Bauelemente zur Signalverarbeitung aufweisenden Signalelektronik (13, 23, 33), einer elektronische Bauelemente zur Leistungsübertragung aufweisenden Leistungselektronik (12, 22, 32) und einem Halter (14, 24, 34) zum Halten der Signalelektronik (13, 23, 33), 1 **dadurch gekennzeichnet, dass** die Leistungselektronik (12, 22, 32) mit Hilfe eines Halters (14, 24, 34) gegen die Grundplatte (11, 21, 31) pressbar ist.

2. Steuergerät (20), nach Anspruch 1, **dadurch gekennzeichnet, dass** der Halter (24) als ein Rahmen ausgeführt ist.

3. Steuergerät (30) nach Anspruch 1 oder 2, **dadurch gekennzeichnet, dass** der Halter (34) an der Grundplatte (31) und/oder an der Signalelektronik (33) mittels Rasthaken (35) und/oder Schrauben und/oder Sprengringen und/oder Nieten befestigbar ist.

4. Steuergerät (10, 20, 30) nach einem der Ansprüche 1 bis 3, **dadurch gekennzeichnet, dass** die Grundplatte (11, 21, 31) mit Durchbrüchen und/oder mit Vertiefungen zur Aufnahme der Leistungselektronik (12, 22, 32) versehen ist.

5. Steuergerät (10, 20, 30) nach einem der Ansprüche 1 bis 4, **dadurch gekennzeichnet, dass** die Leistungselektronik (12, 22, 32) mit Rasthaken an dem Halter (14, 24, 34) fixierbar ist.

6. Steuergerät (10, 20, 30) nach einem der Ansprüche 1 bis 5, **dadurch gekennzeichnet, dass** zwischen der Leistungselektronik (12, 22, 32) und der Grundplatte (11, 21, 31) ein Wärme leitendes Medium anordenbar ist.

7. Steuergerät (10, 20, 30) nach Anspruch 6, **dadurch gekennzeichnet, dass** das Wärme leitende Medium eine Wärmeleitpaste, eine Wärmeleitfolie oder dergleichen ist.

8. Steuergerät (10, 20, 30) nach einem der Ansprüche 1 bis 7, **dadurch gekennzeichnet, dass** die Leistungselektronik (12, 22, 32) mit Federelementen an die Grundplatte (11, 21, 31.) pressbar ist.

9. Steuergerät (10, 20, 30) nach einem der Ansprüche 1 bis 8, **dadurch gekennzeichnet, dass** elektrische Verbindungen zwischen der Leistungselektronik (1.2, 22, 32) und der Signalelektronik (13, 23, 33) durch Bond- und/oder Lötverbindungen und/oder Federelemente erstellbar sind.

10. Lenkung, insbesondere für ein Kraftfahrzeug, **dadurch gekennzeichnet, dass** sie mit einem Steuergerät (10, 20, 30) nach einem der Ansprüche 1 bis 9 ausgerüstet ist.
